# EUROPEAN PATENT APPLICATION

(11) **EP 4 549 344 A1**
(43) Date of publication of application: **07.05.2025**
(21) Application number: 23842705.8
(22) Date of filing: 07.06.2023
(51) Int. Cl.: B65G 1/04

(54) **STACKER CRANE**

(30) Priority: 20.07.2022 JP 2022115385
(71) Applicant: Murata Machinery, Ltd., Kyoto-shi, Kyoto 601-8326 (JP)
(72) Inventor: GOTO Fumiki, Inuyama-shi, Aichi 484-8502 (JP)
(74) Representative: Hoffmann Eitle
(86) International application number: PCT/JP2023/021140
(87) International publication number: WO 2024/018773

(57) **Abstract**

A stacker crane (6) includes a traveling part (70) having a drive wheel being at least one of a first wheel (72) and a second wheel (73) disposed opposing each other across a rail (5) and a moving mechanism (80) configured to move the drive wheel, the first wheel (72), and the second wheel (73). The moving mechanism (80) has a first contact pressure adjustment mechanism (83) and a second contact pressure adjustment mechanism (84) configured to adjust the contact pressure of the drive wheel against the rail (5) by moving the drive wheel in a direction making the first wheel (72) and the second wheel (73) away from each other or a direction making the first wheel (72) and the second wheel (73) closer to each other. One of the first contact pressure adjustment mechanism (83) and the second contact pressure adjustment mechanism (84) is disposed on one side of the drive wheel in a traveling direction of the traveling part (70), and the other of the first contact pressure adjustment mechanism (83) and the second contact pressure adjustment mechanism (84) is disposed on the other side of the drive wheel in the traveling direction.

## Description

### Technical Field

One aspect of the present invention relates to a stacker crane.

### Background Art

For example, Patent Document 1 discloses a stacker crane that, by a biasing mechanism configured to bias one of a pair of wheels putting a rail therebetween toward the rail, can pressurize a drive wheel against the rail. In such a stacker crane, the contact pressure of the drive wheel against the rail can be increased, and thus slipping of the drive wheel on the rail can be reduced, and faster traveling and higher acceleration/deceleration can be achieved. In addition, in such a stacker crane, by releasing the contact pressure of the drive wheel against the rail, the stacker crane can be manually moved.

### Citation List

### Patent Literature

Patent Document 1: Japanese Patent No. 6011628

### Summary of Invention

### Technical Problem

However, the conventional stacker crane's biasing mechanism is provided in part in a traveling direction of the drive wheel. Thus, it may be difficult for an operator's hand to reach the biasing mechanism depending on a stopping position or the like of the stacker crane, and time and effort may be required for adjustment of the biasing mechanism.

Given these circumstances, an object of one aspect of the present invention is to provide a stacker crane that can improve workability when the contact pressure of a drive wheel is adjusted.

### Solution to Problem

A stacker crane according to one aspect of the present invention includes a traveling part having a drive wheel being at least one of a first wheel and a second wheel disposed opposing each other across a rail, and a moving mechanism configured to move the drive wheel, wherein the moving mechanism having a first contact pressure adjustment mechanism and a second contact pressure adjustment mechanism configured to adjust contact pressure of the drive wheel against the rail by moving the drive wheel in a direction making the first wheel and the second wheel away from each other or a direction making the first wheel and the second wheel closer to each other, and one of the first contact pressure adjustment mechanism and the second contact pressure adjustment mechanism being disposed closer to one side in a traveling direction of the traveling part than the drive wheel is and another of the first contact pressure adjustment mechanism and the second contact pressure adjustment mechanism being disposed closer to another side in the traveling direction than the drive wheel is.

The stacker crane of this configuration is provided with the first contact pressure adjustment mechanism and the second contact pressure adjustment mechanism configured to adjust the contact pressure of the drive wheel against the rail on both sides in the traveling direction of the first wheel and the second wheel. This enables an operator to adjust the contact pressure of the drive wheel from both sides in the traveling direction of the drive wheel. Consequently, workability when the contact pressure of the drive wheel is adjusted can be improved.

In the stacker crane according to one aspect of the present invention, the moving mechanism may have a rotating member provided rotatably about a rotating shaft as a rotation center with respect to a main body of the traveling part and to which an axle of the first wheel is fixed, and the first contact pressure adjustment mechanism may be a mechanism configured to move a part of the rotating member in a direction away from the rail or a direction closer to the rail and the second contact pressure adjustment mechanism may be a mechanism configured to move another part different from the part of the rotating member in a direction away from the rail or a direction closer to the rail. With this configuration, the operator can move the first wheel and the second wheel in a direction making the first wheel and the second wheel away from each other or a direction making the first wheel and the second wheel closer to each other from both sides in the traveling direction of the wheels by a simple configuration.

In the stacker crane according to one aspect of the present invention, the rotating shaft may be disposed at a position closer to the rail than the axle of the first wheel is, and the traveling part may be disposed in order of the first contact pressure adjustment mechanism, the rotating shaft, the axle of the first wheel, and the second contact pressure adjustment mechanism from the one side in the traveling direction. With this configuration, the contact pressure of the drive wheel can be adjusted by a simple configuration.

In the stacker crane according to one aspect of the present invention, the first contact pressure adjustment mechanism moves the first wheel away from the rail by moving the part of the rotating member closer to the rail, and the second contact pressure adjustment mechanism moves the first wheel closer to the rail by moving the other part different from the part of the rotating member closer to the rail. With this configuration, the contact pressure of the drive wheel can be adjusted by a simple configuration.

The stacker crane according to one aspect of the present invention may further include a mast provided at an end on the one side in the traveling direction of the traveling part and extending in a vertical direction and a transfer part provided movably in the vertical direction along one side face on the other side in the traveling direction on the mast, in which the first wheel and the second wheel may be disposed between an end on the other side in the traveling direction of the traveling part and the mast in the traveling direction. With this configuration, the first wheel and the second wheel are disposed near a central part of the traveling part, which increases the distance from both ends of the traveling part to the first wheel and the second wheel in the traveling direction. However, in the stacker crane according to one aspect of the present invention, the first contact pressure adjustment mechanism and the second contact pressure adjustment mechanism are provided on both sides of the traveling part in the traveling direction, and thus the contact pressure adjustment for the drive wheel can be easily performed even in a configuration in which the first wheel and the second wheel are provided near the central part of the traveling part.

In the stacker crane according to one aspect of the present invention, the traveling part may have a lower traveling part disposed at a lower end of the mast in the vertical direction and an upper traveling part disposed at an upper end of the mast in the vertical direction, and the moving mechanism may be provided in the upper traveling part. With this configuration, workability when the contact pressure of the drive wheel disposed in the upper traveling part disposed at the upper end of the mast in the vertical direction is adjusted can be improved.

### Advantageous Effects of Invention

One aspect of the present invention can improve workability when the contact pressure of the drive wheel is adjusted.

### Brief Description of Drawings

[FIG. 1] FIG. 1 is a side view illustrating a schematic configuration of a stocker in which a stacker crane according to one embodiment is arranged.
[FIG. 2] FIG. 2 is a side view illustrating a schematic configuration of the stocker in FIG. 1.
[FIG. 3] FIG. 3 is a perspective view illustrating the stacker crane according to the embodiment.
[FIG. 4] FIG. 4 is a perspective view of an upper traveling part in FIG. 3.
[FIG. 5] FIG. 5 is a plan view of the upper traveling part in FIG. 3.
[FIG. 6] FIG. 6 is a side view of the upper traveling part in FIG. 3.

### Description of Embodiments

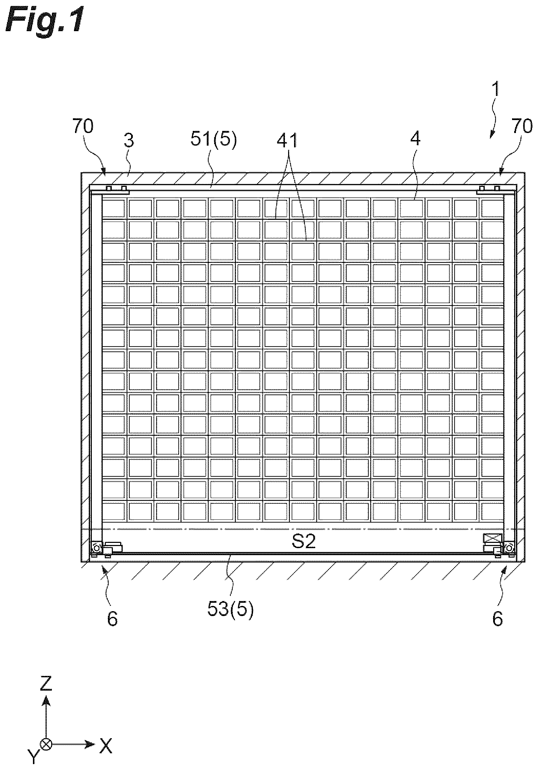

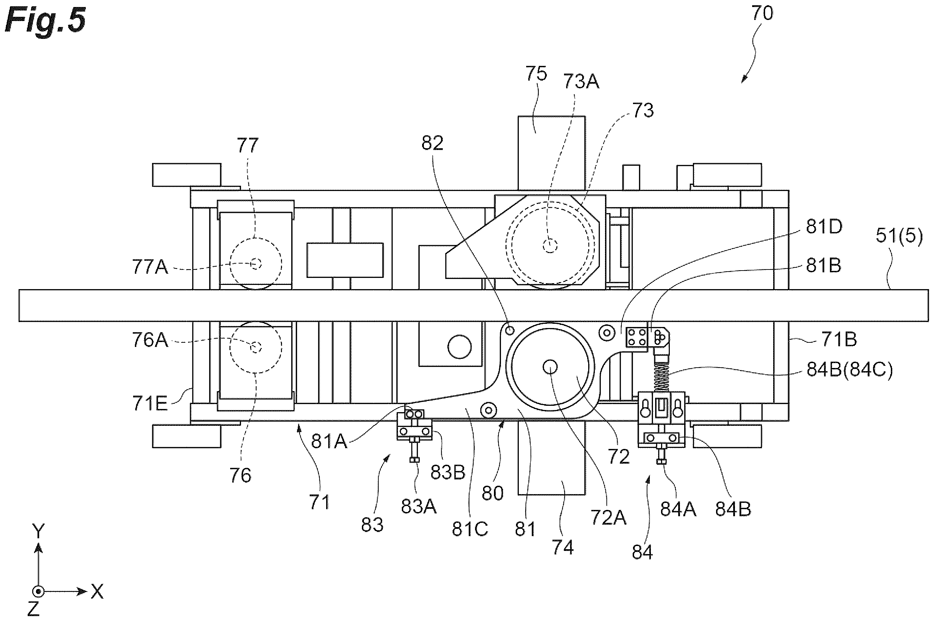

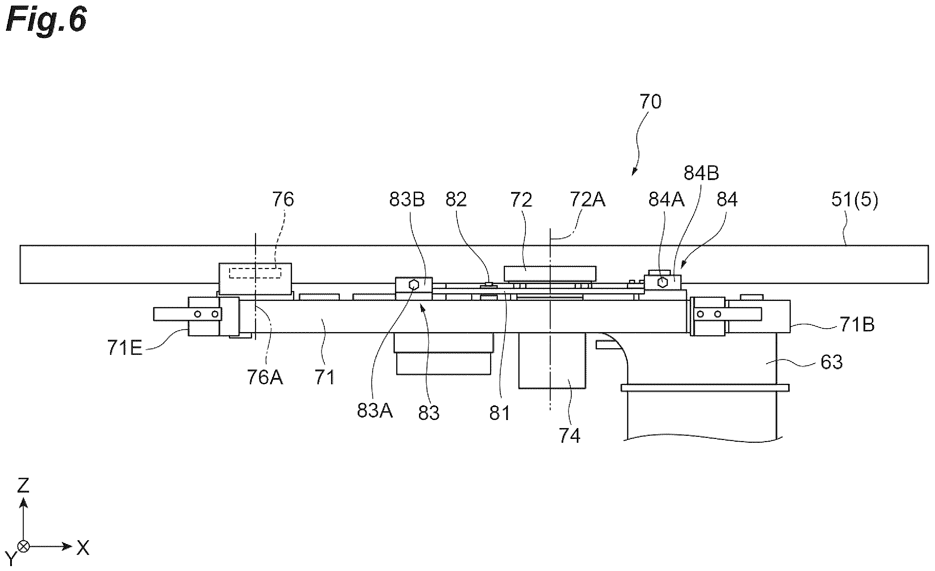

The following describes a stocker 1 in which a stacker crane 6 according to one embodiment is arranged with reference to the accompanying drawings. In the description of the drawings, the same components are denoted by the same symbols, and duplicate descriptions are omitted. For the convenience of description, an X direction, a Y direction, and a Z direction are defined in FIG. 1 to FIG. 6. The X direction is a direction matching a traveling direction of the stacker crane, the Y direction is a direction orthogonal to the X direction and a direction matching a width direction of a stocker main body 3. The Z direction is a direction orthogonal to both the X direction and the Y direction and a direction matching the vertical direction.

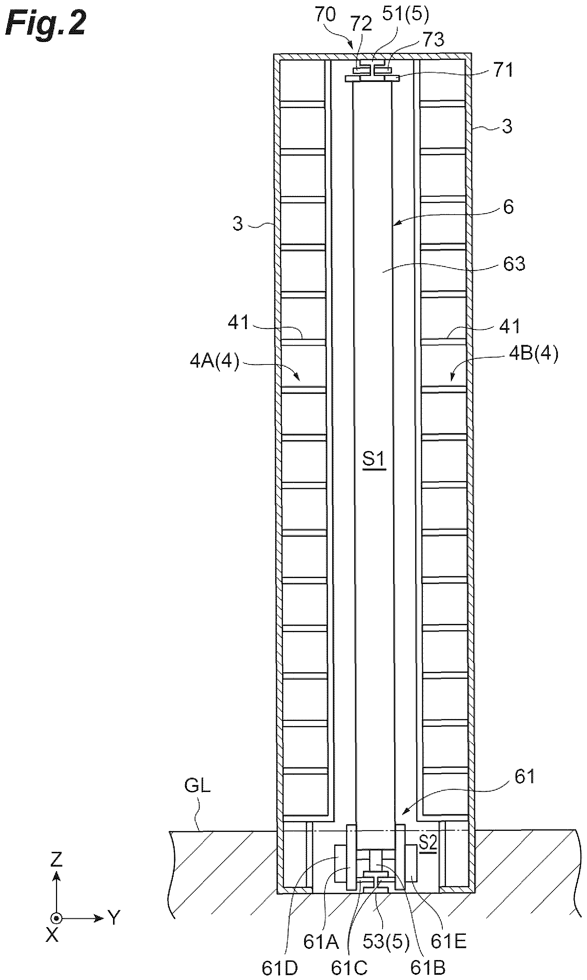

The stocker 1, for example, stores an article having been transported by a transport apparatus. The article is, for example, a container such as a front opening unified pod (FOUP) housing wafers to be processed in semiconductor manufacturing apparatuses or liquid crystal manufacturing apparatuses or a reticle pod housing reticles to be used in semiconductor manufacturing apparatuses or liquid crystal manufacturing apparatuses. As illustrated in FIG. 1 and FIG. 2, the stocker 1 includes a stocker main body 3, a rack 4, a rail 5, and the stacker crane 6.

The stocker main body 3 is formed in a housing shape (for example, a hollow rectangular parallelepiped shape) surrounding a certain area extending in the X direction. The outer shape of the stocker main body 3 is formed by a frame and a panel, which are not illustrated. The stocker main body 3 is formed with an underfloor area S2, which is part of an internal area of the stocker main body 3 at a position lower than a floor surface GL outside the stocker main body 3.

The stocker main body 3 houses racks 4A and 4B and two stacker cranes 6. The racks 4A and 4B are disposed opposing each other in the Y direction across a traveling area S1 of the stacker cranes 6. Each of the racks 4A and 4B has a plurality of shelves 41 on which articles can be placed. In each of the racks 4A and 4B, the shelves 41 are arranged along the X direction and the Y direction.

The rail 5 includes an upper rail (a rail) 51 and a lower rail 53. The upper rail 51 and the lower rail 53 are disposed inside the stocker main body 3 and are disposed opposing each other in the vertical direction. The upper rail 51 extends in the X direction, which is the horizontal direction. The upper rail 51 is directly mounted on the ceiling or the like or mounted on the ceiling or the like via a suspension member. Like the upper rail 51, the lower rail 53 also extends in the X direction, which is the horizontal direction. The lower rail 53 is directly mounted on the ground or mounted on the ground via a support member.

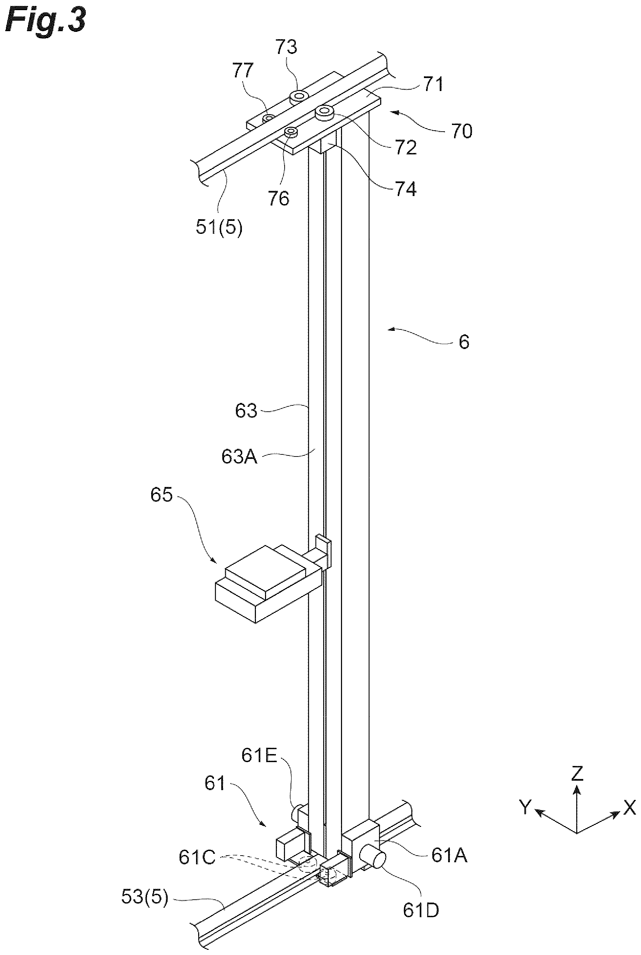

As illustrated in FIG. 2 and FIG. 3, each of the two stacker cranes 6 and 6 includes a lower traveling part 61, a mast 63, a transfer part 65, and an upper traveling part (a traveling part) 70. Since the two stacker cranes 6 and 6 have the same configuration, they are described below simply as the stacker crane 6. In the following description, the stacker crane 6 disposed on the right side in FIG. 1 is illustrated and described.

The lower traveling part 61 travels along the lower rail 53. The lower traveling part 61 has a lower main body 61A, a drive wheel 61B, a pair of driven wheels 61C and 61C, a motor 61D for traveling, and a motor 61E for lifting and lowering. The lower main body 61A includes members such as a frame and a plate and supports the drive wheel 61B, the pair of driven wheels 61C and 61C, the motor 61D for traveling, and the motor 61E for lifting and lowering. The drive wheel 61B is provided so as to be able to roll on an upper face of the lower rail 53. The pair of driven wheels 61C and 61C are provided so as to be able to roll with side faces of the lower rail 53 put therebetween. The motor 61D for traveling is a driving source for the drive wheel 61B. The motor 61E for lifting and lowering is a driving source for the transfer part 65.

The mast 63 is a columnar member extending along the vertical direction. The mast 63 is provided erected from the lower traveling part 61. An upper end of the mast 63 is connected to the upper traveling part 70. The mast 63 is disposed at an end of the lower traveling part 61 on one side in the X direction (a traveling direction of the stacker crane 6) and disposed at an end of the upper traveling part 70 on the one side in the X direction. In other words, the lower traveling part 61 and the upper traveling part 70 project toward the other side in the X direction from the mast 63.

The transfer part 65 transfers articles to and from the shelves 41 and also transfers articles to and from an entry- and-exit port (not illustrated) provided in the stocker main body 3. The transfer part 65 is provided so as to be able to be lifted and lowered along one side face (a lifting and lowering face 63A) of the mast 63. More specifically, the transfer part 65 is provided on the other side of the mast 63 in the X direction, that is, the same side as the direction in which the lower traveling part 61 and upper traveling part 70 protrude from the mast 63. The transfer part 65 is driven by the motor 61E for lifting and lowering.

As illustrated in FIG. 3 to FIG. 6, the upper traveling part 70 mainly has an upper main body 71, a first drive wheel (a first wheel) 72, a second drive wheel (a second wheel) 73, a moving mechanism 80, a motor 74 for the first drive wheel, a motor 75 for the second drive wheel, a first driven wheel 76, and a second driven wheel 77.

The upper main body 71 includes members such as a frame and a plate and supports the first drive wheel 72, the second drive wheel 73, the moving mechanism 80, the motor 74 for the first drive wheel, the motor 75 for the second drive wheel, the first driven wheel 76, and the second driven wheel 77. An end of the upper main body 71 on the one side in the X direction is connected to the mast 63. As described above, the upper traveling part 70 is disposed so as to protrude from mast 63. In the following, for the convenience of description, an end of the upper main body 71 closer to the mast 63 is referred to as a basal end 71B, and an end of the upper main body 71 on the opposite side from the basal end 71B is referred to as a distal end 71E.

The first drive wheel 72 and the second drive wheel 73 are disposed opposing each other in the Y direction and are adjusted so as to put (hold) the upper rail 51 therebetween when the upper traveling part 70 travels. The first drive wheel 72 and the second drive wheel 73 are provided in a central part of the upper main body 71 in the X direction. More specifically, the first drive wheel 72 and the second drive wheel 73 are disposed between the distal end 71E of the upper main body 71 and the lifting and lowering face 63A of the mast 63 in the X direction.

The first drive wheel 72 is a drive wheel driven by the motor 74 for the first drive wheel. The first drive wheel 72 has its axle 72A fixed to the moving mechanism 80 (a rotating member 81), which is described in detail below. The second drive wheel 73 is a drive wheel driven by the motor 75 for the second drive wheel. The second drive wheel 73 has its axle 73A fixed to the upper main body (the main body of the traveling part) 71.

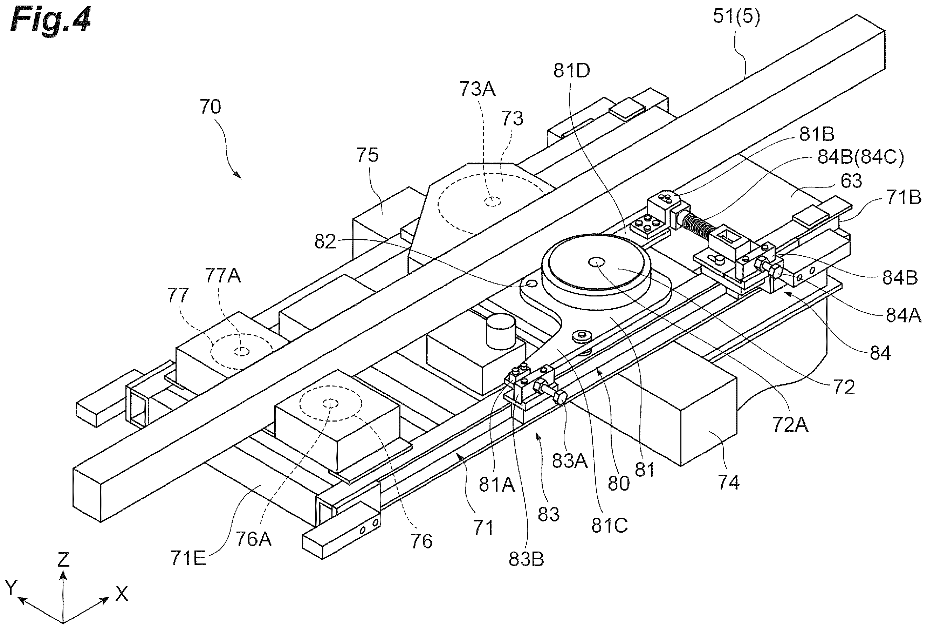

The moving mechanism 80 is a mechanism configured to adjust the contact pressure of the first drive wheel 72 against the upper rail 51. As illustrated in FIG. 4 to FIG. 6, the moving mechanism 80 has the rotating member 81, a rotating shaft 82, a first contact pressure adjustment mechanism 83, and a second contact pressure adjustment mechanism 84. In the upper traveling part 70, the first contact pressure adjustment mechanism 83, the rotating shaft 82, the axle 72A of the first drive wheel 72, and the second contact pressure adjustment mechanism 84 are arranged in this order from the one side in the traveling direction.

The rotating member 81 is provided rotatably about the rotating shaft 82 with respect to the upper main body 71. The rotating shaft 82 is disposed at a position closer to the upper rail 51 than the axle 72A of the first drive wheel 72 is, in the Y direction. The axle 72A of the first drive wheel 72 is fixed to the rotating member 81, and the first drive wheel 72 is provided rotatably about the axle 72A. The first drive wheel 72 provided in the rotating member 81 moves along the Y direction (in the Y direction while also moving in the X direction) along with the rotation of the rotating member 81. This enables the contact pressure of the first drive wheel 72 against the upper rail 51 to be adjusted. The rotating member 81 is formed with a first projecting part 81C projecting toward the distal end 71E and a second projecting part 81D projecting toward the basal end 71B.

In the present embodiment, when the first projecting part 81C is moved closer to the upper rail 51, the entire rotating member 81 rotates clockwise in plan view about the rotating shaft 82, and the first drive wheel 72 becomes away from the upper rail 51 (that is, the first drive wheel 72 moves in a direction away from the second drive wheel 73). On the other hand, when the first projecting part 81C is moved away from the upper rail 51, the entire rotating member 81 rotates counterclockwise in plan view about the rotating shaft 82, and the first drive wheel 72 becomes closer to the upper rail 51 (that is, the first drive wheel 72 moves in a direction closer to the second drive wheel 73). Note that the rotating member 81 is biased by the second contact pressure adjustment mechanism 84 so as to rotate counterclockwise in plan view about the rotating shaft 82. Note that plan view in this context means a view viewing from above in the axial direction. In the following, when simply referring to "clockwise" or "counterclockwise," too, it means "clockwise" in plan view or "counterclockwise" in plan view.

The first contact pressure adjustment mechanism 83 is a mechanism configured to move the first projecting part (a part of the rotating member) 81C of such a rotating member 81 in the Y direction. That is, the first contact pressure adjustment mechanism 83 is a mechanism configured to adjust the contact pressure of the first drive wheel 72 against the upper rail 51 by moving the first drive wheel 72 in the Y direction.

The first contact pressure adjustment mechanism 83 has a bolt 83A and a fixed part 83B. The bolt 83A is screwed into the fixed part 83B. In the first contact pressure adjustment mechanism 83, by rotating the bolt 83A clockwise, the tip of the bolt 83A moves closer to the upper rail 51 and presses a block part 81A of the rotating member 81. This rotates the rotating member 81 clockwise about the rotating shaft 82, and along with this rotation, the first drive wheel 72 becomes away from the upper rail 51 (that is, the first drive wheel 72 moves in a direction away from the second drive wheel 73). Consequently, a certain contact pressure state of the first drive wheel 72 against the upper rail 51 is released.

In the first contact pressure adjustment mechanism 83, by rotating the bolt 83A counterclockwise, the tip of the bolt 83A moves away from the upper rail 51. This rotates the rotating member 81, which is biased to rotate counterclockwise by a compression spring 84C, counterclockwise about the rotating shaft 82, and along with this rotation, the first drive wheel 72 becomes closer to the upper rail 51 (that is, the first drive wheel 72 moves in a direction closer to the second drive wheel 73). Consequently, the first drive wheel 72 becomes in the certain contact pressure state against the upper rail 51.

In the present embodiment, when the second projecting part 81D is moved closer to the upper rail 51, the entire rotating member 81 rotates counterclockwise about the rotating shaft 82, and the first drive wheel 72 becomes closer to the upper rail 51 (that is, the first drive wheel 72 moves in a direction closer to the second drive wheel 73). On the other hand, when the second projecting part 81D is moved away from the upper rail 51, the entire rotating member 81 rotates clockwise about the rotating shaft 82, and the first drive wheel 72 becomes away from the upper rail 51 (that is, the first drive wheel 72 moves in a direction away from the second drive wheel 73).

The second contact pressure adjustment mechanism 84 is a mechanism configured to move the second projecting part (another part different from the part of the rotating member) 81D of such a rotating member 81 in the Y direction. That is, the second contact pressure adjustment mechanism 84 is a mechanism configured to adjust the contact pressure of the first drive wheel 72 against the upper rail 51 by moving the first drive wheel 72 in the Y direction.

The second contact pressure adjustment mechanism 84 has a bolt 84A, a fixed part 84B, and the compression spring 84C. The bolt 84A is screwed into the fixed part 84B. In the second contact pressure adjustment mechanism 84, by rotating the bolt 84A clockwise, the compression spring 84C provided on the tip of the bolt 84A moves closer to the upper rail 51 and presses a block part 81B of the rotating member 81. This rotates the rotating member 81 counterclockwise about the rotating shaft 82, and along with this rotation, the first drive wheel 72 becomes closer to the upper rail 51 (that is, the first drive wheel 72 moves in a direction closer to the second drive wheel 73). Consequently, the first drive wheel 72 becomes in the certain contact pressure state against the upper rail 51.

In the second contact pressure adjustment mechanism 84, by rotating the bolt 84A counterclockwise, the pressing force of the compression spring 84C provided on the tip of the bolt 83A against the block part 81B reduces. This enables the rotating member 81 to rotate clockwise about the rotating shaft 82, and along with this rotation, the first drive wheel 72 becomes away from the upper rail 51 (that is, the first drive wheel 72 moves in a direction away from the second drive wheel 73). Consequently, the certain contact pressure state of the first drive wheel 72 against the upper rail 51 is released.

One of the first contact pressure adjustment mechanism 83 and the second contact pressure adjustment mechanism 84 is disposed closer to the one side in the traveling direction of the upper traveling part 70 (the X direction) than the first drive wheel 72 is, and the other of the first contact pressure adjustment mechanism 83 and the second contact pressure adjustment mechanism 84 is disposed closer to the other side in the traveling direction than the first drive wheel 72 is. In the present embodiment, the first contact pressure adjustment mechanism 83 is disposed closer to the distal end 71E of the upper main body 71 than the first drive wheel 72 is, and the second contact pressure adjustment mechanism 84 is disposed closer to the basal end 71B of the upper main body 71 than the first drive wheel 72 is.

The following describes working effects of the stacker crane 6 according to the above embodiment. The stacker crane 6 according to the above embodiment is provided with the first contact pressure adjustment mechanism 83 and the second contact pressure adjustment mechanism 84 configured to adjust the contact pressure of the first drive wheel 72 against the upper rail 51 on both sides in the traveling direction of the first drive wheel 72 and the second drive wheel 73. This enables an operator to adjust the contact pressure of the first drive wheel 72 from both sides in the traveling direction of the first drive wheel 72. For example, if the stacker crane 6 breaks down and becomes unable to travel by itself, the operator operates one of the first contact pressure adjustment mechanism 83 and the second contact pressure adjustment mechanism 84 to release the contact pressure on the upper rail 51 by the first drive wheel 72 and can move the stacker crane 6 manually. Consequently, workability when the contact pressure of the first drive wheel 72 is adjusted can be improved.

In the stacker crane 6 according to the above embodiment, the first contact pressure adjustment mechanism 83 is a mechanism configured to move the first projecting part 81C, which is a part of the rotating member 81, in the Y direction, and the second contact pressure adjustment mechanism 84 is a mechanism configured to move the second projecting part 81D, which is another part different from the part of the rotating member 81, in the Y direction. With this configuration, the first drive wheel 72 can be moved in the Y direction from both sides in the traveling direction of the first drive wheel 72 by a simple configuration.

In the stacker crane 6 according to the above embodiment, the rotating shaft 82 of the rotating member 81 is disposed at a position closer to the upper rail 51 than the axle 72A of the first drive wheel 72 is, and in the upper traveling part 70, the first contact pressure adjustment mechanism 83, the rotating shaft 82, the axle 72A of the first drive wheel 72, and the second contact pressure adjustment mechanism 84 are arranged in this order from the one side in the traveling direction (closer to the distal end 71E). This enables the contact pressure of the first drive wheel 72 to be adjusted by a simple configuration.

In the stacker crane 6 according to the above embodiment, the first contact pressure adjustment mechanism 83 moves the first drive wheel 72 away (apart) from the upper rail 51 by moving the first projecting part 81C closer to the upper rail 51, and the second contact pressure adjustment mechanism 84 moves the first drive wheel 72 closer to the upper rail 51 by moving the second projecting part 81D closer to the upper rail 51. This enables the contact pressure of the first drive wheel 72 to be adjusted by a simple configuration.

In the stacker crane 6 according to the above embodiment, the first drive wheel 72 is disposed between the distal end 71E in the traveling direction of the upper traveling part 70 (the upper main body 71) and the mast 63 in the traveling direction. In such a configuration, the first drive wheel 72 is disposed near a central part of the upper traveling part 70, and the distance from the distal end 71E and the basal end 71B, which are both ends of the upper traveling part 70, to the first drive wheel 72 is long in the traveling direction. However, in the stacker crane 6 according to the above embodiment, the first contact pressure adjustment mechanism 83 and the second contact pressure adjustment mechanism 84 are provided on both sides of the upper traveling part 70 in the traveling direction, and thus the contact pressure adjustment for the first drive wheel 72 can be easily performed even in a configuration in which the first drive wheel 72 is provided near the central part of the upper traveling part 70.

The stacker crane 6 according to the above embodiment can improve workability when the contact pressure of the first drive wheel 72 disposed in the upper traveling part 70 disposed at the upper end of the mast 63 in the vertical direction is adjusted.

The embodiment has been described above, but one aspect of the present invention is not limited to the above embodiment. Various modifications can be made within a scope not departing from the gist of the invention.

In the above embodiment, a configuration has been described, as an example, in which only the first drive wheel 72 out of the two first drive wheel 72 and second drive wheel 73 putting the upper rail 51 therebetween is provided movably along the Y direction, but the second drive wheel 73 may also be provided movably along the Y direction in a similar manner. That is, in addition to the configuration of the stacker crane 6 according to the above embodiment, the moving mechanism 80 dedicated to the second drive wheel 73 may be provided.

In the above embodiment, an example has been described in which the two first drive wheel 72 and second drive wheel 73 putting the upper rail 51 therebetween are provided, but a driven wheel having no driving force may be disposed instead of the second drive wheel 73.

In the above embodiment and modifications, the moving mechanism 80 configured to move the first drive wheel 72 in the Y direction by rotating the rotating member 81 has been presented as an example and an example has been described in which the first contact pressure adjustment mechanism 83 and the second contact pressure adjustment mechanism 84 are provided as means to rotate the rotating member 81. However, one aspect of the present invention is not limited to this configuration. For example, the first drive wheel 72 may be moved in the Y direction by moving a slide member in the Y direction, and the first contact pressure adjustment mechanism 83 and the second contact pressure adjustment mechanism 84 configured to move the slide member may be provided.

In the above embodiment and modifications, an example has been described in which one aspect of the present invention is applied to the upper traveling part 70, but instead of or in addition to this configuration, one aspect of the present invention may be applied to the lower traveling part 61.

### Reference Signs List

- 1: stocker

- 5: rail
- 6: stacker crane
- 51: upper rail (rail)
- 63: mast
- 65: transfer part
- 70: upper traveling part (traveling part)
- 71: upper main body (main body of traveling part)
- 72: first drive wheel (first wheel)
- 73: second drive wheel (second wheel)
- 74: motor for first drive wheel
- 75: motor for second drive wheel
- 76: first driven wheel
- 77: second driven wheel
- 80: moving mechanism
- 81: rotating member
- 81C: first projecting part (part of rotating member)
- 81D: second projecting part (another part different from part of rotating member)
- 82: rotating shaft
- 83: first contact pressure adjustment mechanism
- 84: second contact pressure adjustment mechanism

## Claims

1. A stacker crane comprising a traveling part having a drive wheel being at least one of a first wheel and a second wheel disposed opposing each other across a rail, and a moving mechanism configured to move the drive wheel, wherein
the moving mechanism having a first contact pressure adjustment mechanism and a second contact pressure adjustment mechanism configured to adjust contact pressure of the drive wheel against the rail by moving the drive wheel in a direction in which the first wheel and the second wheel move away from each other or a direction in which the first wheel and the second wheel move closer to each other, and
one of the first contact pressure adjustment mechanism and the second contact pressure adjustment mechanism being disposed closer to one side in a traveling direction of the traveling part than the drive wheel is and another of the first contact pressure adjustment mechanism and the second contact pressure adjustment mechanism being disposed closer to another side in the traveling direction than the drive wheel is.

2. The stacker crane according to claim 1, wherein
the moving mechanism has a rotating member provided rotatably about a rotating shaft as a rotation center with respect to a main body of the traveling part and to which an axle of the first wheel is fixed, and
the first contact pressure adjustment mechanism is a mechanism configured to move a part of the rotating member in a direction away from the rail or a direction closer to the rail and the second contact pressure adjustment mechanism is a mechanism configured to move another part different from the part of the rotating member in a direction away from the rail or a direction closer to the rail.

3. The stacker crane according to claim 2, wherein
the rotating shaft is disposed at a position closer to the rail than the axle of the first wheel is, and
the traveling part is disposed in order of the first contact pressure adjustment mechanism, the rotating shaft, the axle of the first wheel, and the second contact pressure adjustment mechanism from the one side in the traveling direction.

4. The stacker crane according to claim 3, wherein
the first contact pressure adjustment mechanism moves the first wheel away from the rail by moving the part of the rotating member closer to the rail, and
the second contact pressure adjustment mechanism moves the first wheel closer to the rail by moving the other part different from the part of the rotating member closer to the rail.

5. The stacker crane according to any one of claims 1 to 4, further comprising:
a mast provided at an end on the one side in the traveling direction of the traveling part and extending in a vertical direction; and
a transfer part provided movably in the vertical direction along one side face on the other side in the traveling direction on the mast, wherein
the first wheel and the second wheel are disposed between an end on the other side in the traveling direction of the traveling part and the mast in the traveling direction.

6. The stacker crane according to claim 5, wherein
the traveling part has a lower traveling part disposed at a lower end of the mast in the vertical direction and an upper traveling part disposed at an upper end of the mast in the vertical direction, and
the moving mechanism is provided in the upper traveling part.
